# EUROPÄISCHE PATENTSCHRIFT

(11) **EP 1 208 727 B1**
(45) Veröffentlichungstag und Bekanntmachung des Hinweises auf die Patenterteilung: **04.08.2004**
(21) Anmeldenummer: 01929482.6
(22) Anmeldetag: 30.03.2001
(51) Int. Cl.: H05K 7/14

(54) **VORRICHTUNG UND BRÜCKENKARTE FÜR EINEN COMPUTER**
DEVICE AND BRIDGE CARD FOR A COMPUTER
DISPOSITIF ET CARTE EN PONT POUR UN ORDINATEUR

(30) Priorität: 04.07.2000 DE 10032339
(43) Veröffentlichungstag der Anmeldung: 29.05.2002
(73) Patentinhaber: Hartmann Elektronik GmbH, 70499 Stuttgart (DE)
(72) Erfinder: BROSOWSKI, Hans-Otto, 70825 Korntal-Münchingen (DE)
(74) Vertreter: Dreiss, Fuhlendorf, Steimle & Becker
(86) Internationale Anmeldenummer: PCT/EP2001/003670
(87) Internationale Veröffentlichungsnummer: WO 2002/003769

(56) Entgegenhaltungen:
- DE-A- 2 806 762
- US-A- 5 006 961
- US-A- 5 308 926
- US-A- 6 067 594

## Beschreibung

### Stand der Technik

Die Erfindung geht aus von einer Vorrichtung für einen Computer mit mindestens zwei Platinen, auf denen Stecker für Einsteckkarten vorhanden sind, die mit einer ersten Höhe über die Platinen überstehen, und mit einer Brückenkarte, die in die beiden Platinen eingesteckt ist, über die die beiden Platinen elektrisch miteinander gekoppelt sind, und die mit einer zweiten Höhe über die Platinen übersteht. Die Erfindung betrifft ebenfalls eine entsprechende Brückenkarte für einen Computer.

Eine derartige Vorrichtung ist beispielsweise bei einem Personalcomputer bekannt, bei dem zwei sogenannte Bus-Karten über die Brückenkarte elektrisch und funktionell miteinander gekoppelt sind. Mit Hilfe der Brückenkarte ist es möglich, die Anzahl der durch die Bus-Karten zur Verfügung gestellten Einsteckplätze zu erhöhen. In die Einsteckplätze können Einsteckkarten, beispielsweise Adapterkarten für an den Computer anzuschließende Geräte eingesteckt werden.

Bekannterweise ist die Brückenkarte mit Gegensteckern versehen, die in die Stecker der beiden Platinen eingesteckt werden können. Im eingesteckten Zustand belegt die Brückenkarte damit jeweils einen Stecker der beiden Platinen.

Die Brückenkarte ist üblicherweise mit einem integrierten Chip versehen, der der elektrischen und funktionellen Kopplung der beiden Platinen dient. Insbesondere ist der Chip dazu geeignet, Auswahlsignale zur Auswahl bestimmter Einsteckplätze zu erzeugen und zwischen den Platinen zu übertragen.

Die Baugröße des Chips hat zur Folge, dass die Brückenkarte nicht nur diejenigen beiden Stecker der Platinen überdeckt, in die sie eingesteckt ist, sondern zusätzlich auch noch die beiden jeweils nächsten Stecker der beiden Platinen. Dies bedeutet, dass die Brückenkarte nicht nur zwei, sondern insgesamt vier Stecker der beiden Platinen belegt.

Der Nachteil der bekannten Brückenkarte besteht somit darin, dass ihr Vorhandensein automatisch mit der Belegung von Einsteckplätzen der beiden Platinen verbunden ist. In diese Einsteckplätze können keine Einsteckkarten mehr eingesteckt werden, so dass die an sich mit Hilfe der Brückenkarte erreichbare Erhöhung der zur Verfügung stehenden Einsteckplätze beim Stand der Technik tatsächlich nicht erreicht wird.

### Aufgabe und Vorteile der Erfindung

Aufgabe der Erfindung ist es, eine Vorrichtung bzw. eine Brückenkarte für einen Computer zu schaffen, bei der alle möglichen Einsteckplätze auch tatsächlich zur Verfügung stehen.

Diese Aufgabe wird bei einer Vorrichtung der eingangs genannten Art erfindungsgemäß dadurch gelöst, dass die Brückenkarte unabhängig von den Steckern mit den beiden Platinen verbunden ist, und dass die erste Höhe größer ist als die zweite Höhe.

Dies bedeutet mit anderen Worten, dass die Brückenkarte nicht mehr in die Stecker der beiden Platinen eingesteckt wird. Schon allein durch diese Maßnahme wird erreicht, dass im Vergleich zum Stand der Technik zwei Einsteckplätze mehr zur Verfügung stehen.

Weiterhin wird durch die Größenverhältnisse der beiden Höhen zueinander erreicht, dass die Brückenkarte insgesamt in einem geringeren Maß über die Platinen übersteht als die Stecker, in die die Einsteckkarten eingesteckt werden. Damit können die Einsteckkarten in diese Stecker der Platinen eingesteckt werden, ohne dass sie in irgend einer Weise mit der Brückenkarte kollidieren. Sind Einsteckkarten in die Stecker der beiden Platinen eingesteckt, so befindet sich die Brückenkarte somit letztlich unterhalb der eingesteckten Einsteckkarten. Damit werden durch die Brückenkarte auch insoweit keinerlei Einsteckplätze mehr blockiert.

Insgesamt wird mit Hilfe der Erfindung erreicht, dass durch die Verwendung der erfindungsgemäßen Brückenkarte die Anzahl der erreichbaren Einsteckplätze auch tatsächlich erreicht wird. Es werden also keinerlei Einsteckplätze mehr aufgrund der Brückenkarte verschenkt. Dies hat ersichtliche Vorteile im Hinblick auf den Aufbau des Computers sowie insbesondere im Hinblick auf die entstehenden Kosten.

Bei vorteilhaften Weiterbildungen der Erfindung sind die beiden Platinen mit einem Abstand nebeneinander und etwa in einer gemeinsamen Ebene angeordnet und/oder es ist die Brückenkarte etwa parallel zu den Platinen angeordnet.

Eine besonders vorteilhafte Ausgestaltung der Erfindung ist dadurch gekennzeichnet, dass die Brückenkarte mit mindestens zwei Gegensteckern versehen ist, dass die beiden Platinen mit jeweils mindestens einem Stecker versehen sind, in die die Gegenstecker der Brückenkarte eingesteckt sind, und dass die beiden Platinen über die Stecker und die Gegenstecker mit der Brückenkarte elektrisch verbunden sind.

Es sind also gesonderte Stecker und Gegenstecker vorgesehen, mit denen die Brückenkarte mit den beiden Platinen verbunden ist. Dies eröffnet die Möglichkeit, diese Stecker und Gegenstecker derart flach oder klein auszubilden, dass die zweite Höhe kleiner bleibt als die erste Höhe. Letztlich wird also die Erfindung in diesem Fall durch entsprechend ausgebildete Stecker und Gegenstecker realisiert.

Bei vorteilhaften Weiterbildungen der Erfindung sind die Stecker für die Einsteckkarten, die Stecker und die Gegenstecker etwa parallel zueinander angeordnet. Weiterhin ist es vorteilhaft, wenn sich die zweite Höhe aus der Höhe der Brückenkarte, der Stecker, der Gegenstecker und des Chips ergibt. Zweckmäßig ist es, wenn die Brückenkarte mit einem Chip versehen ist.

Bei besonders vorteilhaften Ausgestaltungen der Erfindung gehören die Stecker zu einem PCI-Bus, insbesondere zu einem Compact-PCI-Bus.

Die Erfindung wird ebenfalls durch eine Brückenkarte für einen Computer realisiert, wobei der Computer mit mindestens zwei Platinen versehen ist, auf denen Stecker für Einsteckkarten vorhanden sind, die mit einer ersten Höhe über die Platinen überstehen, wobei die Brückenkarte in die beiden Platinen einsteckbar ist, wobei die beiden Platinen über die eingesteckte Brückenkarte elektrisch miteinander koppelbar sind, und wobei die eingesteckte Brückenkarte mit einer zweiten Höhe über die Platinen übersteht. Erfindungsgemäß ist die Brückenkarte unabhängig von den Steckern mit den beiden Platinen verbunden, und es ist die Brückenkarte derart ausgebildet, dass die zweite Höhe kleiner ist als die erste Höhe.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

### Ausführungsbeispiele der Erfindung

- Figur 1: zeigt eine schematische Draufsicht auf ein Ausführungsbeispiels einer erfindungsgemäßen Vorrichtung für einen Computer, und
- Figur 2: zeigt eine schematische Seitenansicht aus der Richtung II auf die Vorrichtung der Figur 1.

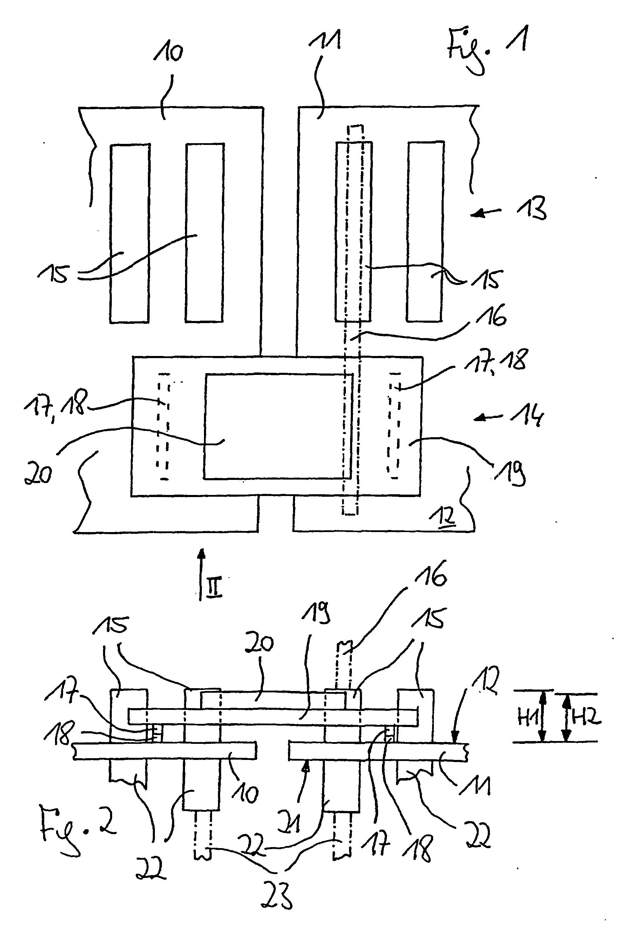

In den Figuren 1 und 2 sind zwei Platinen 10, 11 für einen Computer dargestellt. Bei den Platinen 10, 11 handelt es sich insbesondere um sogenannte Bus-Karten eines Industrie- oder Personalcomputers. Die Platinen 10, 11 sind mit einem Abstand nebeneinander und etwa in einer gemeinsamen Ebene angeordnet.

In der Figur 1 sind die Rückseiten 12 der Platinen 10, 11 dargestellt. Bei der genannten Bus-Karte ist diese Rückseite 12 in einen oberen und einen unteren Bereich 13, 14 aufgeteilt.

In dem oberen Bereich 13 der Rückseite 12 sind Stecker 15 vorgesehen, die an den Platinen 10, 11 befestigt sind und von dieser abstehen. In die Stecker 15 können Einsteckkarten, z.B. Adapterkarten für einen anzuschließenden Drucker oder dergleichen eingesteckt werden. Eine derartige eingesteckte Einsteckkarte ist in den Figuren 1 und 2 beispielhaft strichpunktiert dargestellt und mit dem Bezugszeichen 16 gekennzeichnet.

In dem unteren Bereich 14 der Rückseite 12 sind Stecker 18 vorgesehen, die ebenfalls an den Platinen 10, 11 befestigt sind und von dieser abstehen. In die Stecker 18 sind Gegenstecker 17 eingesteckt, die an der Unterseite einer Brückenkarte 19 befestigt sind und von dieser abstehen.

Auf der Oberseite oder auf der Unterseite der Brückenkarte 19 ist ein integrierter Chip 20 vorhanden. Über die Brückenkarte 19 und mit Hilfe des Chips 20 sind die beiden Platinen 10, 11 elektrisch und funktionell miteinander gekoppelt.

Auf der Brückenkarte 19 sind zwei derartige Gegenstecker 17 vorhanden. Jeder der beiden Gegenstecker 17 ist einem Stecker 18 einer der beiden Platinen 10, 11 zugeordnet. Daraus ergibt sich eine elektrische Verbindung von der Platine 10 über den Stecker 18 und den Gegenstecker 17 zu der Brückenkarte 19 und von dort über den Chip 20, den Gegenstecker 17 und den Stecker 18 zu der Platine 11.

Die Brückenkarte 19 ist etwa parallel zu den beiden Platinen 10, 11 angeordnet. Weiterhin überlappt die Brückenkarte 19 jede der beiden Platinen 10, 11 innerhalb des unteren Bereichs 14. Die Brückenkarte 19 erstreckt sich dabei jeweils etwa bis zu dem zweiten Stecker 15 der beiden Platinen 10, 11.

Die Stecker 15, die Stecker 18 und die Gegenstecker 17 sind etwa parallel zueinander ausgerichtet. Die Stecker 18 mit den Gegensteckern 17 sind etwa in der Mitte zwischen zwei Steckern 15 angeordnet. Auf der Platine 10 und auf der Platine 11 ist jeweils ein Stecker 18 mit eingestecktem Gegenstecker 17 vorhanden. Der Stecker 18 und/oder der Gegenstecker 17 kann dabei zweiteilig ausgebildet sein.

Auf der Vorderseite 21 der Platinen 10, 11 sind weitere Stecker 22 angeordnet. In die Stecker 22 können weitere Steckkarten eingesteckt werden, die in der Figur 2 beispielhaft strichpunktiert dargestellt und mit dem Bezugszeichen 23 gekennzeichnet sind. Bei einer dieser Steckkarten kann es sich um eine CPU-Karte handeln, die damit den Prozessor des gesamten Computers trägt.

Auf jeder der beiden Platinen 10, 11 sind die Pins der Stecker 22 der Vorderseite 21 jeweils elektrisch miteinander verbunden und bilden auf jeder der beiden Platinen 10, 11 einen Bus. Die Leiterbahnen dieses Buses sind insbesondere im unteren Bereich 14 der Platinen 10, 11 angeordnet. Weiterhin ist auf den Platinen 10, 11 im oberen Bereich 13 jeder der Stecker 15 der Rückseite 12 mit dem jeweils gegenüberliegenden Stecker 22 der Vorderseite 21 pinweise verbunden.

Der Abstand der Stecker 15, 22 beträgt 20,32 mm. Die beiden Platinen 10, 11 sind derart nebeneinander angeordnet, dass das von den Steckern 15, 22 gebildete Abstandsraster erhalten bleibt. Die Brückenkarte 19 ist vorzugsweise ebenfalls an dieses Abstandsraster angepasst.

Auf jeder der beiden Platinen 10, 11 ist der vorstehend genannte Bus und gegebenenfalls weitere Pins der miteinander verbundenen Stecker 15, 22 mit den Pins des zu der jeweiligen Platine 10, 11 zugehörigen Steckers 18 elektrisch verbunden.

Die Pins der beiden auf der Brückenkarte 19 vorhandenen Gegenstecker 17 sind über den Chip 20 miteinander gekoppelt. Der Chip 20 ist dabei ein elektronischer Baustein, der unter anderem zur Verarbeitung von Signalen geeignet ist, die an den Gegensteckern 17 anliegen. So ist der Chip beispielsweise dazu geeignet, sogenannte Auswahlsignale für die einzelnen Einsteckkarten 16 der beiden Platinen 10, 11 zu erzeugen und/oder zwischen den beiden Platinen 10, 11 zu übermitteln.

Wie aus der Figur 2 zu entnehmen ist, weisen die Stecker 15 eine bestimmte erste Höhe H1 auf, mit der sie über die Platinen 10, 11 überstehen. Weiterhin weisen die Stecker 18, die Gegenstecker 17, die Brückenkarte 19 und der Chip 20 zusammen eine bestimmte zweite Höhe H2 auf, mit der sie über die Platinen 10, 11 überstehen. Befindet sich der Chip 20 auf der Unterseite der Brückenkarte 19, so trägt er nichts zur zweiten Höhe H2 bei.

Wie aus der Figur 2 zu entnehmen ist, ist die erste Höhe H1 größer als die zweite Höhe H2.

Dies wird insbesondere dadurch erreicht, dass die Stecker 18 und die Gegenstecker 17 derart flach bzw. klein ausgebildet sind, dass die gesamte zweite Höhe H2 kleiner bleibt als die erste Höhe H1.

Gegebenenfalls muss bei der Wahl der zweiten Höhe H2 berücksichtigt werden, dass die in die Stecker 15 eingesteckten Steckkarten 16 geringfügig über die Stecker 15 überstehen und damit die erste Höhe H1 entsprechend vermindern.

Damit können auch in diejenigen Stecker 15 Einsteckkarten 16 eingesteckt werden, in deren unterem Bereich 14 die Brückenkarte 19 mit dem Chip 20 vorhanden ist. Die in diese Stecker 15 eingesteckten Einsteckkarten 16 werden gemäß der Figur 2 durch die Brückenkarte 19 oder den Chip 20 nicht beeinflusst. Insbesondere können die Einsteckkarten 16 vollständig in diese Stecker 15 eingesteckt werden, ohne dass die Einsteckkarten 16 die Brückenkarte 19 oder den Chip 20 berühren. Die Brückenkarte 19 und der Chip 20 befinden sich dann vollständig unterhalb der in diese Stecker 15 eingesteckten Einsteckkarten 16.

Es wird ausdrücklich darauf hingewiesen, dass die beiden Platinen 10, 11 auch in der Form einer einzigen Platine vorhanden sein können. In diesem Fall sind dann auf der einen Platine zwei Hälften vorhanden, die im Wesentlichen den beiden Platinen 10, 11 entsprechen. Diese beiden Hälften können dann in derselben Weise miteinander gekoppelt werden wie die beiden Platinen 10, 11, und zwar durch eine auf die Platine aufgesteckte Brückenkarte.

Weiterhin wird darauf hingewiesen, dass die Platinen 10, 11 wie auch die vorstehend beschriebene zusammengefasste Platine mehrfach kaskadiert werden können.

## Patentansprüche

1. Vorrichtung für einen Computer mit mindestens zwei Platinen (10, 11), auf denen Stecker (15) für Einsteckkarten (16) vorhanden sind, die mit einer ersten Höhe (H1) über die Platinen (10, 11) überstehen, und mit einer Brückenkarte (19), die in die beiden Platinen (10, 11) eingesteckt ist, über die die beiden Platinen (10, 11) elektrisch miteinander gekoppelt sind, und die mit einer zweiten Höhe (H2) über die Platinen (10, 11) übersteht, **dadurch gekennzeichnet, dass** die Brückenkarte (19) unabhängig von den Steckern (15) mit den beiden Platinen verbunden ist, und dass die erste Höhe (H1) größer ist als die zweite Höhe (H2).

2. Vorrichtung nach Anspruch 1, **dadurch gekennzeichnet, dass** die beiden Platinen (10, 11) mit einem Abstand nebeneinander und etwa in einer gemeinsamen Ebene angeordnet sind.

3. Vorrichtung nach Anspruch 1 oder 2, **dadurch gekennzeichnet, dass** die Brückenkarte (19) etwa parallel zu den Platinen (10, 11) angeordnet ist.

4. Vorrichtung nach einem der Ansprüche 1 bis 3, **dadurch gekennzeichnet, dass** die Brückenkarte (19) mit mindestens zwei Gegensteckern (18) versehen ist, dass die beiden Platinen (10, 11) mit jeweils mindestens einem Stecker (17) versehen sind, in die die Gegenstecker (18) der Brückenkarte (19) eingesteckt sind, und dass die beiden Platinen (10, 11) über die Stecker (17) und die Gegenstecker (18) mit der Brückenkarte (19) elektrisch verbunden sind.

5. Vorrichtung nach Anspruch 4, **dadurch gekennzeichnet, dass** die Stecker (15) für die Einsteckkarten, die Stecker (18) und die Gegenstecker (17) etwa parallel zueinander angeordnet sind.

6. Vorrichtung nach Anspruch 4 oder 5, **dadurch gekennzeichnet, dass** die zweite Höhe (H2) sich aus der Höhe der Brückenkarte (19), der Stecker (18), der Gegenstecker (17) und gegebenenfalls des Chips (20) ergibt.

7. Vorrichtung nach einem der Ansprüche 1 bis 6, **dadurch gekennzeichnet, dass** die Brückenkarte (19) mit einem Chip (20) versehen ist.

8. Vorrichtung nach einem der vorstehenden Ansprüche, **dadurch gekennzeichnet, dass** die Stecker (15) zu einem PCI-Bus, insbesondere zu einem Compact-PCI-Bus gehören.

9. Brückenkarte (19) für einen Computer, wobei der Computer mit mindestens zwei Platinen (10, 11) versehen ist, auf denen Stecker (15) für Einsteckkarten (16) vorhanden sind, die mit einer ersten Höhe (H1) über die Platinen (10, 11) überstehen, wobei die Brückenkarte (19) in die beiden Platinen (10, 11) einsteckbar ist, wobei die beiden Platinen (10, 11) über die eingesteckte Brückenkarte (19) elektrisch miteinander koppelbar sind, und wobei die eingesteckte Brückenkarte (19) mit einer zweiten Höhe (H2) über die Platinen (10, 11) übersteht, **dadurch gekennzeichnet, dass** die Brückenkarte (19) unabhängig von den Steckern (15) mit den beiden Platinen (10, 11) verbunden ist, und dass die Brückenkarte (19) derart ausgebildet ist, dass die zweite Höhe (H2) kleiner ist als die erste Höhe (H1).

10. Vorrichtung oder Brückenkarte (19) nach einem der vorstehenden Ansprüche, **dadurch gekennzeichnet, dass** anstelle der mindestens zwei Platinen (10, 11) eine einzige Platine vorgesehen ist.

## Claims

1. Device for a computer comprising at least two circuit boards (10, 11) on which plugs (15) for plug-in cards (16) are present, which plugs project with a first height (H1) above the circuit boards (10, 11), and comprising a bridge card (19) which is plugged into the two circuit boards (10, 11) and via which the two circuit boards (10, 11) are electrically coupled to one another, and which project with a second height (H2) above the circuit boards (10, 11), **characterized in that** the bridge card (19) is connected to the two circuit boards independently of the plugs (15), and that the first height (H1) is greater than the second height (H2).

2. Device according to Claim 1, **characterized in that** the two circuit boards (10, 11) are arranged a distance apart and approximately in a common plane.

3. Device according to Claim 1 or 2, **characterized in that** the bridge card (19) is arranged approximately parallel to the circuit boards (10, 11).

4. Device according to any of Claims 1 to 3, **characterized in that** the bridge card (19) is provided with at least two counter-plugs (18), that the two circuit boards (10, 11) are provided in each case with at least one plug (17) into which the counter-plugs (18) of the bridge card (19) are plugged, and that the two circuit boards (10, 11) are electrically connected to the bridge card (19) via the plugs (17) and the counter-plugs (18).

5. Device according to Claim 4, **characterized in that** the plugs (15) for the plug-in cards, the plugs (18) and the counter-plugs (17) are arranged approximately parallel to one another.

6. Device according to Claim 4 or 5, **characterized in that** the second height (H2) arises from the height of the bridge card (19), of the plugs (18), of the counter-plugs (17) and optionally of the chip (20).

7. Device according to any of Claims 1 to 6, **characterized in that** the bridge card (19) is provided with a chip (20).

8. Device according to any of the preceding Claims, **characterized in that** the plugs (15) belong to a PCI bus, in particular to a compact PCI bus.

9. Bridge card (19) for a computer, the computer being provided with at least two circuit boards (10, 11), on which plugs (15) for plug-in cards (16) are present, which plugs project with a first height (H1) above the circuit boards (10, 11), the bridge card (19) being capable of being plugged into the two circuit boards (10, 11), the two circuit boards (10, 11) being capable of being coupled electrically to one another via the plugged-in bridge card (19), and the plugged-in bridge card (19) projecting with a second height (H2) above the circuit boards (10, 11), **characterized in that** the bridge card (19) is connected to the two circuit boards (10, 11) independently of the plugs (15), and that the bridge card (19) is formed in such a way that the second height (H2) is less than the first height (H1).

10. Device or bridge card (19) according to any of the preceding Claims, **characterized in that** a single circuit board is provided instead of the at least two circuit boards (10, 11).

## Revendications

1. Dispositif destiné à un ordinateur comportant au moins deux platines (10, 11), sur lesquelles sont placés des connecteurs (15) pour des cartes enfichables (16), lesquels connecteurs dépassent des platines (10, 11) d'une première hauteur (H1), et comportant une carte pont (19), qui est enfichée dans les deux platines (10, 11), permettant de coupler l'une à l'autre les deux platines (10, 11) par voie électrique, et laquelle carte pont dépasse des platines (10, 11) d'une deuxième hauteur (H2), **caractérisé en ce que** la carte pont (19) est reliée aux deux platines indépendamment des connecteurs (15), et **en ce que** la première hauteur (H1) est supérieure à la deuxième hauteur (H2).

2. Dispositif selon la revendication 1, **caractérisé en ce que** les deux platines (10, 11) sont disposées à côté et à une certaine distance l'une de l'autre, et sont quasiment disposées dans un même plan.

3. Dispositif selon l'une quelconque des revendications 1 ou 2, **caractérisé en ce que** la carte pont (19) est disposée en étant quasiment parallèle aux platines (10, 11).

4. Dispositif selon l'une quelconque des revendications 1 à 3, **caractérisé en ce que** la carte pont (19) est dotée d'au moins deux connecteurs inverses (18), **en ce que** les deux platines (10, 11) sont respectivement dotées d'au moins un connecteur (17) dans lequel est enfiché le connecteur inverse (18) de la carte pont (19), et **en ce que** les deux platines (10, 11) sont reliées par voie électrique à la carte pont (19) par l'intermédiaire des connecteurs (17) et des connecteurs inverses (18).

5. Dispositif selon la revendication 4, **caractérisé en ce que** les connecteurs (15) destinés aux cartes enfichables, à savoir les connecteurs (18) et connecteurs inverses (17), sont disposés en étant quasiment parallèles les uns aux autres.

6. Dispositif selon l'une quelconque des revendications 4 ou 5, **caractérisé en ce que** la deuxième hauteur (H2) se déduit de la hauteur de la carte pont (19), des connecteurs (18), des connecteurs inverses (17) et le cas échéant de la puce (20).

7. Dispositif selon l'une quelconque des revendications 1 à 6, **caractérisé en ce que** la carte pont (19) est dotée d'une puce (20).

8. Dispositif selon l'une quelconque des revendications précédentes, **caractérisé en ce que** les connecteurs (15) appartiennent à un bus PCI, en particulier à un bus Compact PCI.

9. Carte pont (19) destinée à un ordinateur, moyennant quoi l'ordinateur est doté d'au moins deux platines (10, 11) sur lesquelles sont placés des connecteurs (15) pour des cartes enfichables (16), lesquels connecteurs dépassent des platines (10, 11) d'une première hauteur (H1), moyennant quoi la carte pont (19) peut être enfichée dans les deux platines (10, 11), moyennant quoi les deux platines (10, 11) peuvent être couplées l'une à l'autre par voie électrique à l'aide de la carte pont (19) enfichée, et moyennant quoi la carte pont (19) enfichée dépasse des platines (10, 11) d'une deuxième hauteur (H2), **caractérisé en ce que** la carte pont (19) est reliée aux deux platines (10, 11) indépendamment des connecteurs (15), et **en ce que** la carte pont (19) est configurée de telle sorte que la deuxième hauteur (H2) est inférieure à la première hauteur (H1).

10. Dispositif ou carte pont (19) selon l'une quelconque des revendications précédentes, **caractérisé en ce que**, au lieu des au moins deux platines (10, 11), on prévoit une seule platine.
